Europäisches Patentamt

European Patent Office

Office européen des brevets

(11) Veröffentlichungsnummer: **0 305 697 B1**

## (12) EUROPÄISCHE PATENTSCHRIFT

(45) Veröffentlichungstag der Patentschrift: **11.03.92**

(21) Anmeldenummer: **88111250.2**

(22) Anmeldetag: **13.07.88**

(51) Int. Cl.5: **H05K 3/34**, H05K 13/04, B23K 1/00

---

(54) Verfahren zum Einlöten von SMD-Bauteilen, die zeitweise an einem mittels Vakuumleitung evakuierbaren Lötkopf gehalten werden.

---

(30) Priorität: **31.08.87 DE 3729046**

(43) Veröffentlichungstag der Anmeldung:
**08.03.89 Patentblatt 89/10**

(45) Bekanntmachung des Hinweises auf die Patenterteilung:
**11.03.92 Patentblatt 92/11**

(84) Benannte Vertragsstaaten:
**AT BE CH DE FR GB IT LI NL SE**

(56) Entgegenhaltungen:
**EP-A- 0 231 096**
**US-A- 4 295 596**

**IBM TECHNICAL DISCLOSURE BULLETIN, Band 11, Nr. 10, MÄrz 1969, Seite 1298, New York, US; C. TROLLMAN: "Solder reflow tool"**

(73) Patentinhaber: **SIEMENS AKTIENGESELL-SCHAFT**
**Wittelsbacherplatz 2**
**W-8000 München 2(DE)**

(72) Erfinder: **Bunz, Georg**
**Jean-Paul-Richter-Strasse 23**
**W-8000 München 70(DE)**

## Beschreibung

Die Erfindung betrifft ein verfahren zum Einlöten von Bauelementen, die an einem mittels Vakuumleitung evakuierbaren Lötkopf gehalten werden, insbesondere für oberflächenmontierbare Bauelemente (SMD) wobei nach dem Einlöten Kühlgas auf die Bauelemente geleitet wird.

Ein solches Verfahren ist aus der Druckschrift IBM Technical Disclosure Bulletin, Bd. 11, Nr. 10, März 1969, Seit 1298, bekannt.

Bei der Fertigung von elektronischen Flachbaugruppen ist in der letzten Zeit ein Übergang von der herkömmlichen Technik der Einsteckmontage zur Technik der Oberflächenmontage von flach auflötbaren Bauelementen zu verzeichnen. Die hierbei eingesetzten oberflächenmontierbaren Bauelemente (SMD ≙ Surface Mounted Devices) werden durch Bestückautomaten auf den Leiterplatten positioniert, meistens mittels mehrerer Klebstoffpunkte fixiert und anschließend durch ein übliches Lötverfahren verlötet, womit die elektrische Verbindung hergestellt ist. Die bei derartigen Verfahren auftretenden Fehler, sei es durch Einbau falscher oder defekter Bauelemente oder zum Beispiel durch falsche Positionierung müssen in einem seperaten Verfahren durch Auslöten der entsprechenden Bauelemente und entsprechender Korrektur durch fehlerfreies Einlöten von neuen Bauelementen beseitigt werden. Dies geschieht mittels Vorrichtungen, die man im allgemeinen als Ein- und Auslötmaschinen bezeichnet. Derartige auf dem Markt erhältliche Maschinen müssen einer Vielzahl von Qualitätsanforderungen genügen. So ist es erforderlich, daß der Platz eines defekten Bauelementes, welches ausgelötet und durch fehlerfreies Einlöten eines funktionsfähigen Bauelementes ersetzt werden soll, ohne Behinderungen und ohne Parallaxen-Fehler zu betrachten ist. Des weiteren muß die Heizeinrichtung, mit der die Anschlußbeine des Bauelementes zum Aus- oder Einlöten beheizt werden, eine gleichmäßige Temperaturverteilung über die verschiedenen Anschlußbeine aufweisen und darf zugleich den Körper des Bauelementes nicht zu sehr erhitzen. Ebenso werden hohe Anforderungen an die Ausrichtung des Bauelementes bezüglich der Leiterplatte und des Lötplatzes, an die exakte Dosierung von Lotpaste, an die Kühlung des Bauelementes nach dem Einlöten, sowie an die Handhabung eines durch den Bestückautomaten aufgeklebten Bauelementes beim Auslöten in der Ein- oder Auslötmaschine gestellt.

Insbesondere die Forderung nach ausreichender Kühlung des SMD-Bauelementes, das hauptsächlich durch Wärmeleitung von den beheizten Anschlußbeinen her erwärmt wird, ist bisher nicht ausreichend erfüllt.

Der Erfindung liegt die Aufgabe zugrunde, durch ein Verfahren an einer Ein- und Auslötmaschine eine derartige Kühlung der SMD-Bauelemente bereitzustellen, daß eine Nacherhitzung nach dem Einlöten vermieden wird.

Die Lösung dieser Aufgabe wird durch die kennzeichnenden Merkmale des Anspruches 1 beschrieben.

Während des Einlötens werden die Anschlußbeine eines Bauteils zusammen mit entsprechenden Anschlußflecken auf einer Leiterplatte auf die Löttemperatur erhitzt.

Während dieser Phase erwärmt sich der Körper des Bauelementes durch Wärmeleitung, hinkt jedoch in der Temperatur zeitlich hinter der Temperatur an den Lötstellen hinterher. Ist der Aufheiz- und Lötvorgang beendet, so wird die weitere Wärmeübertragung von den umliegenden heißen Teilen der Apparatur auf den Körper des Bauelementes dadurch vermieden, daß eine Kühlung eingesetzt wird. Das erfindungsgemäße Vorgehen beinhaltet das Einleiten eines Kühlgases in die Vakuumleitung, mittels der das Bauelement vorher durch Ansaugen gehalten wurde. Es ist ersichtlich, daß in diesem Moment das Bauteil von der Halterung durch das Vakuum freigegeben wird und das Kühlgas über die Oberfläche des Bauelementes geblasen wird. Wenn eine Begrenzung der Bauteiltemperatur auf z.B. 260°C über maximal 10 Sekunden vorgegeben ist, so reicht ein etwa 10 Sekunden langes Blasen mit Kühlgas aus, um übliche SMD-Bauelemente vor einer Nacherhitzung zu schützen. Als Kühlgas ist Luft mit Raumtemperatur einsetzbar.

Anhand einer schematischen Darstellung wird ein Ausführungsbeispiel beschrieben.

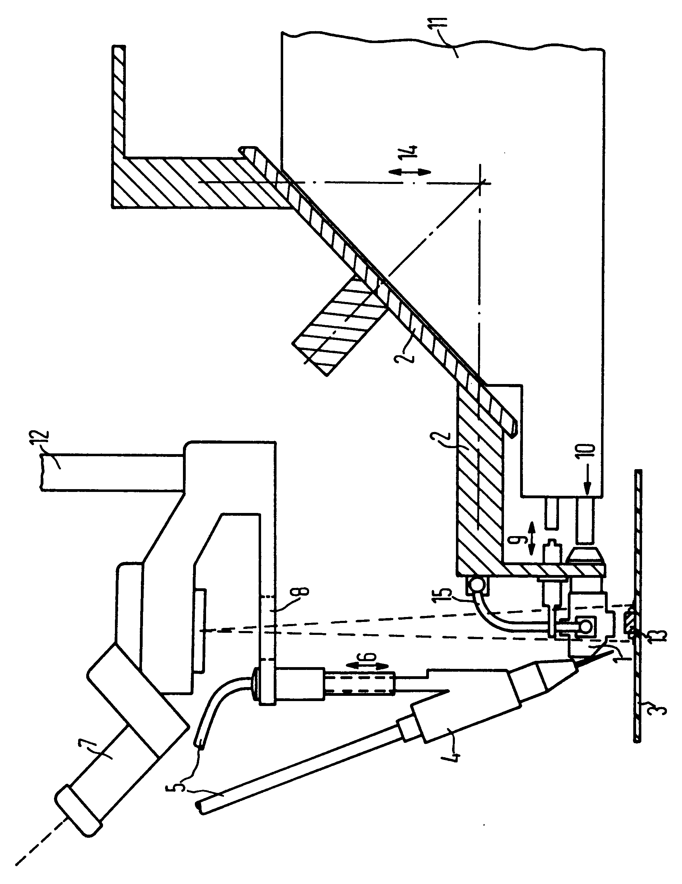

Die Figur zeigt eine Gesamtübersicht einer Ein- oder Auslötmaschine mit einem Lötkopf, der über einen Vakuumanschluß SMD-Bauelemente ansaugen und festhalten kann.

Die Figur enthält folgende wesentlichen Teile:
- den Lötkopf 1
- den Drehteller 2
- die Leiterplatte 3
- ein SMD-Bauelement 13
- eine Dosiervorrichtung 4 für Lotpaste mit
- Druckluftanschluß 5 und
- Hubzylinder 6, sowie
- Sichtfenster 8
- eine Optik 7, hier ein Mikroskop
- ein Stativ 12 für die Optik 7 und Dosiervorrichtung 4
- ein Stativ 11 für den Drehteller 2 mit
- einer Hubeinrichtung 14
- eine Vakuumleitung 15
- einen Hubzylinder 9
- eine Heißgaszuführung 10.

Der am Drehteller 2 über einen Auslegearm befestigte Lötkopf 1 ist in seiner Arbeitsstellung derart positioniert und arretiert, daß mittels der Optik 7 das SMD-Bauelement 13 von oben durch das Sichtfenster 8 und durch den Lötkopf hindurch betrachtet werden kann.

Durch Drehen des Drehtellers 2 können verschiedene an ihm über Auslegearme befestigte Lötköpfe bereit gestellt und in Arbeitsposition geschwenkt werden. Dargestellt ist lediglich ein zweiter Auslegearm, der jedoch nicht mit einem Lötkopf 1 versehen ist. Zum Ein- oder Auslöten wird über die Heißgaszuführung 10 dem Lötkopf 1 ein Heißgas zugeführt, daß im Lötkopf 1 auf die Anschlußbeine des SMD-Bauteils 13 geleitet wird und diese auf die nötige Löttemperatur von beispielsweise 210° oder 225° C erhitzt. Über den Hubzylinder 9 werden die im Lötkopf 1 enthaltenen Zentrierbakken betätigt, die das SMD-Bauelement 13 zeitweise zentrieren und festhalten. Eine weitere Halterung des SMD-Bauelementes 13 am Lötkopf 1 ist durch eine Vakuumeinrichtung gegeben, die über eine Vakuumleitung 15 versorgt wird. Die exakte Positionierung des Lötkopfes 1 relativ zu dem SMD-Bauelement 13 geschieht zum einen durch die in x/y-Richtung mögliche Verschiebung der Leiterplatte 3, sowie über die Hubeinrichtung 14, die den Lötkopf bezüglich der Höhe einstellt. Die Dosiervorrichtung 4 wird über die Druckluftanschlüsse 5 versorgt und durch den Hubzylinder 6 zum Aufbringen einer genau dosierten Menge von Lotpaste auf die Leiterplatte senkrecht nach oben oder nach unten bewegt. Auch hier ermöglicht die Optik 7 zusammen mit der senkrechten Betrachtungsweise durch den Lötkopf 1 hindurch eine parallaxenfreie Betrachung des Ein- oder Auslötplatzes. Hierzu sind durch die Optik 7 in der Regel nur die Anschlußbeine des SMD-Bauteiles 13 sichtbar. Der zentral sitzende Körper des SMD-Bauteiles 13 ist durch die Vakuumeinrichtung verdeckt, die das Bauteil zeitweise hält.

Eine derartige Ein- oder Auslötmaschine für SMD-Bauteile 13 ist durch den Einsatz von Computerprogrammen automatisierbar. Hierzu sind drei wesentliche Arbeitsschritte zu benennen - das Auslöten, das Dosieren der Lotpaste, das Einlöten eines neuen SMD-Bauteiles.

Der Ablauf ist wie folgt:

Auslöten

Über eine Grobjustierung wird der Lötkopf 1 ca. 20 mm über das SMD-Bauteil 13 gefahren und anschließend über eine Feinjustierung auf ca. 1 bis 2 mm angenähert und in x/y-Richtung ausgerichtet, so daß er direkt über dem Bauteil steht. Mittels des über den Lötkopf geführten Heißgases 10 werden die Anschlußbeine des SMD-Bauelementes 13 von Raumtemperatur mit einer Geschwindigkeit von etwa 1,5° C pro Sekunde bis auf ca. 200° C aufgeheizt. Anschließend wird der Lötkopf 1 auf das Bauelement 13 abgesetzt und das Vakuum eingeschaltet, wodurch das Bauelement am Lötkopf angesaugt und gehalten wird. Während des nun einsetzenden eigentlichen Auslötprozesses wird innerhalb von 5 bis 15 Sekunden die Temperatur von 200 bis 210° C oder beispielsweise 225° C erhöht und das Lot zum Fließen gebracht. Der Lötkopf hebt anschließend mit dem Bauelement ab. Die angegebenen Zahlenwerte beziehen sich auf den Einsatz einer üblichen Lotpaste.

Dosieren

Bei in Arbeitsposition eingeschwenktem oder auch ausgeschwenktem Lötkopf 1 wird über die Dosiervorrichtung 4 eine exakt dosierte Menge Lötpaste auf die Anschlußflecken auf der Leiterplatte 3 aufgebracht. Dazu wird die Dosiervorrichtung 4 bis auf einen Abstand von ca. 1 bis 2 mm zur Leiterplatte 3 abgesenkt. Der Hubzylinder 6 sorgt für das Absenken einer Dosiernadel der Dosiervorrichtung 4. Die Menge der notwendigen Lotpaste kann über den Druck in der Druckluftzuführung 5, über die Zeit oder über den Durchmesser der Dosiernadel gesteuert werden.

Einlöten

Das Einlöten geschieht in entsprechender Weise wie das Auslöten. Das SMD-Bauelement 13 wird von dem Lötkopf 1 aufgenommen, mittels Zentrierbacken zentriert und über ein Vakuum festgehalten. Die Zentrierbacken sind in diesem Zustand wieder gelöst. Nach einer Grobpositionierung erfolgt das Absenken auf die Leiterplatte und die Feinjustierung, wobei mit der Opitk 7 kontrolliert wird. Innerhalb der ersten Phase des Aufheizens wird wiederum mit einer Geschwindigkeit von ca. 1,5° C pro Sekunde bis auf ca. 200° C vorgeheizt und beispielsweise beim Einsatz einer handelsüblichen Lotpaste innerhalb von weiteren 5 bis 15 Sekunden auf ca. 225° C erhitzt. Die Halterung durch Ansaugen mittels Vakuum wird anschließend abgeschaltet, wobei gleichzeitig, um eine Nacherhitzung des Körpers der SMD-Bauteile 13 zu vermeiden, etwa 10 Sekunden lang kalte Luft direkt über die Vakuumleitung auf das SMD-Bauelement geblasen wird. Der Lötkopf 1 hebt nun ab und der Einlötvorgang ist beendet.

**Patentansprüche**

1. Verfahren zum Einlöten von Bauelementen (13), die an einem mittels Vakuumleitung (15) evakuierbaren Lötkopf (1) gehalten werden, insbesondere für oberflächenmontierbare Bauelemente (SMD) wobei nach dem Einlöten Kühlgas auf die Bauelemente geleitet wird, dadurch **gekennzeichnet,** daß die Bauelemente (13) nach dem Einlöten durch Einleiten des Kühlgases in die Vakuumleitung (15) gekühlt werden.

## Claims

1. Method for soldering components (13), which are held on a solder head (1) which can be evacuated by means of a vacuum line (15), preferably for surface mounted components (SMD), cooling gas being directed onto the components after soldering, characterised in that the components (13) are cooled after soldering by the introduction of the cooling gas into the vacuum line (15).

## Revendications

1. Procédé de soudage d'éléments (13), qui sont maintenus sur une tête de soudage (1) susceptible d'être mise sous vide au moyen d'un conduit (15) destiné à faire le vide, notamment pour des éléments susceptibles d'être montés en surface (SMD), en envoyant, après le soudage, du gaz de refroidissement sur les éléments, caractérisé en ce que les éléments (13) sont refroidis après le soudage par envoi du gaz de refroidissement dans le conduit (15) destiné à faire le vide.